# EUROPEAN PATENT SPECIFICATION

(11) **EP 4 567 444 B1**
(45) Date of publication and mention of the grant of the patent: **30.09.2026**
(21) Application number: 23921748.2
(22) Date of filing: 15.02.2023
(51) Int. Cl.: G01R 31/385, G01R 1/04, G01R 1/067, G01R 1/073, G01R 31/28

(54) **TESTING APPARATUS AND METHOD OF RANGE ADJUSTMENT FOR SAME**
PRÜFVORRICHTUNG UND ABSTANDSEINSTELLUNGSVERFAHREN DAFÜR
DISPOSITIF DE TEST ET PROCÉDÉ DE RÉGLAGE DE LA DISTANCE ASSOCIÉ

(43) Date of publication of application: 11.06.2025
(73) Proprietor: Contemporary Amperex Technology Co., Limited, Ningde, Fujian 352100 (CN)
(72) Inventor: XUE, Wen, Ningde, Fujian 352100 (CN); WANG, Jiacai, Ningde, Fujian 352100 (CN); HE, Muqing, Ningde, Fujian 352100 (CN); WANG, Lili, Ningde, Fujian 352100 (CN)
(74) Representative: Lorenz Seidler Gossel Part. mbB
(86) International application number: PCT/CN2023/076170
(87) International publication number: WO 2024/168584

(56) References cited:
- CN-A- 111 044 920
- CN-A- 114 062 738
- CN-A- 115 032 539
- CN-A- 115 032 539
- CN-A- 115 166 436
- CN-A- 115 166 436
- CN-A- 115 453 163
- CN-A- 115 453 163
- CN-U- 212 321 799
- CN-U- 214 503 842
- CN-U- 216 354 347
- JP-A- 2010 078 576

## Description

### Technical Field

The present application relates to the technical filed of battery testing, and in particular to a testing apparatus and a method of range adjustment for the same.

### Background

Probes are commonly used as test interfaces for battery performance testing, for example, battery insulation testing and voltage testing. In probe testing, a probe is used as a mating device structure crimped onto an electrode terminal of a battery, facilitating an indirect connection between the electrode terminal on the battery and a testing device.

A testing apparatus according to the preamble of claim 1 is known from document CN 115 453 163 A. Further prior art is known from CN 115 032 539 A and CN 115 166 436 A.

With the diversification of battery designs, in order to match the testing of batteries in different specifications, a reasonable range adjustment is required for the probe. However, due to the design flaws of a traditional testing apparatus, range adjustment usually refers to manual adjustment or semi-automatic adjustment, which is not only time-consuming and laborious, and difficult to meet the battery production takt, but also has a poor range adjustment accuracy, which seriously affects the reliability of testing results.

### Summary of the Invention

Based on this, it is necessary to provide a testing apparatus and a method of range adjustment for the same, which save time and effort and meet the production takt, and can effectively improve the range adjustment accuracy y.

In a first aspect, the present invention refers to a testing apparatus according to claim 1.

In some embodiments, the adjustment mechanism includes a first driving module and a pushing member, the first driving module is configured to drive the pushing member to move in the second direction until it abuts against the probe assembly and to push the probe assembly. In this way, the first driving module is used to drive the pushing member to move in the second direction to push the probe assembly to move in the second direction, achieving effective adjustment of the probe assembly in the second direction.

In some embodiments, the adjustment mechanism further includes a lifter connected to the pushing member, the first driving module is spaced apart in a third direction from the connection mechanism and configured to drive the lifter to move in the second direction, and the lifter is configured to drive the pushing member to move in the third direction, the third direction being perpendicular to the first direction and the second direction, respectively. In this way, the lifter is provided to drive the pushing member to move in the third direction, so that the pushing member is allowed to extend into the connection mechanism, thus enabling the pushing member to act better on the probe assembly and achieving effective range adjustment.

In some embodiments, the connection mechanism further includes a locking structure, and the locking structure is configured to lock the range-adjusted probe assembly, so as to restrict the probe assembly from moving in the second direction. In this way, the locking structure is used to lock the probe assembly so that the probe assembly does not continue to move in the second direction, the probe assembly is allowed to make a stable contact with the part to be tested, which is conducive to improving the testing stability.

In some embodiments, the locking structure includes a clamping member and a first driving member disposed on the mount, the probe assembly is at least partially located between the clamping member and the mount, and the first driving member is configured to drive the clamping member to move, so as to clamp or release the probe assembly. In this way, the locking structure is designed as the first driving member and the clamping member, so that the probe assembly is restricted to the mount in a clamping manner, facilitating a locking operation of the probe assembly.

In some embodiments, the clamping member is provided with a limiting slot extending in the second direction, the probe assembly is provided with a limiting protrusion, and a slot wall of the limiting slot is allowed to abut against or be separated from the limiting protrusion when driven by the first driving member. In this way, the matching between the limiting protrusion and the limiting slot can not only improve smoothness in movement of the probe assembly, but also lock the movement of the probe assembly, so that the probe assembly acts accurately on the part to be tested.

In some embodiments, the moving mechanism includes a second driving module and a mating device and a carrier that are disposed on the second driving module, the mount is movably disposed on the carrier in the first direction, the second driving module is configured to drive the mating device to move in the first direction, the second driving module is configured to drive the mating device to move in the first direction, and the mating device is configured to be mated or unmated with the mount. In this way, under the action of the second driving module, the mating device can be mated with the mount in the first direction and move the mount to a desired position, thereby achieving effective range adjustment in the first direction.

In some embodiments, the moving mechanism further includes a slide carriage movably disposed on the carrier in the first direction, the mount is disposed on the slide carriage, and the mating device is configured to be mated or unmated with the mount by means of the slide carriage. In this way, since the slide carriage is movably arranged on the carrier, the mount is moved more stably, which is conducive to improving the range adjustment accuracy, and also facilitates the mating between the mating device and the mount, and improving convenience in the range adjustment operation.

In some embodiments, the mating device comprises a second driving member and a positioning member driven to extend or retract by the second driving member, and the slide carriage is provided with a positioning hole for insertion of the positioning member. In this way, the matching between the positioning member and the positioning hole allows for a quick connection and disconnection between the mating device and the slide carriage, thereby improving the range adjustment efficiency.

In some embodiments, the moving mechanism further includes a brake, the brake being disposed on the slide carriage and configured to restrict the slide carriage from moving in the first direction. In this way, the brake is applied to restrict the slide carriage from continuing to move in the first direction and the slide carriage is allowed to stay steadily in a desired position, thereby improving the range adjustment accuracy, and facilitating improvement of the reliability of the testing results.

In some embodiments, at least two connection mechanisms are provided, mounts of all the connection mechanisms are spaced apart in the first direction, and the mating device is allowed to be selectively mated to one of the mounts under the action of the second driving module. With such a design, range adjustment of one of the mounts in the first direction can be achieved selectively, so that the testing apparatus can meet testing requirements for parts to be tested in more specifications, and the range of application of the testing apparatus is expanded.

According to the present invention, the connection mechanism includes a wire arrangement structure and a wire harness, the wire arrangement structure extends in the first direction and is capable of moving in the second direction, the wire harness is wound on the wire arrangement structure and electrically connected to the probe assembly, and the wire harness on at least one side of the probe assembly in the first direction has a bending section. In this way, the wire arrangement structure is designed to be capable of moving in the second direction, so that the wire arrangement structure keeps moving simultaneously with the probe assembly in the second direction, thus reducing the risk of disconnection due to the probe assembly moving in the second direction; and moreover, since the wire harness is wound on the wire arrangement structure by means of the bending section, the risk of wire breakage due to the probe assembly moving in the first direction is reduced.

According to the present invention, the moving mechanism is provided with two supporting members spaced apart in the first direction, the wire arrangement structure includes two sliding members and a carrying member connected between the two sliding members, the sliding members are slidably disposed on the corresponding supporting member in the second direction, and the wire harness is wound on the carrying member. In this way, the wire arrangement structure is designed as the sliding members and the carrying member, so that the wire arrangement structure can move synchronously with the probe assembly in the second direction, and moreover, the wire harness is allowed to be carried steadily, making it unnecessary to arrange the wire harness during range adjustment.

In some embodiments, the wire arrangement structure further includes a guide wheel, the guide wheel sleeves the carrying member, and the wire harness is wound on the guide wheel. In this way, with the guide wheel, the wear of the wire harness as it moves on the carrying member can be reduced, which is conducive to prolonging service life of the wire harness.

In some embodiments, the testing apparatus further includes an auxiliary mechanism, and a testing end of the auxiliary mechanism is configured to be in contact with a shell of the part to be tested. In this way, with the auxiliary mechanism, other specific testing requirements on the part to be tested can be met, which is conducive to improving testing functions of the testing apparatus.

In a second aspect, the present invention refers to a method of range adjustment according to claim 13.

**In** the method of range adjustment for a testing apparatus described above, by the adjustment steps in which the moving mechanism and the adjustment mechanism are integrated in use, automatic adjustment in at least two dimensions is achieved. Compared with a traditional probe testing apparatus, the testing apparatus has the advantages of saving time and effort, improving the testing efficiency and meeting the production takt and moreover, reducing manual operation errors and effectively improving the range adjustment accuracy of the probe assembly.

In some embodiments, the step of controlling the moving mechanism to work to drive the mount to move in the first direction includes controlling the second driving module to work to drive the mating device to move in the first direction to the slide carriage of the mount; controlling the second driving member of the mating device to work to drive the positioning member to extend out and be inserted into the positioning hole of the slide carriage; and controlling the second driving module to work to drive the mating device to move in the first direction so as to move the mount to a first preset position. In this way, the second driving module and the mating device are used together so that the mount moves steadily to the first preset position in the case that the mating device is mated or unmated with the mount, thereby effectively completing the range adjustment in the first direction.

In some embodiments, the step of controlling the adjustment mechanism to work to drive the probe assembly to move in the second direction includes controlling the first driving module to work to drive the lifter to move in the second direction to one side of the probe assembly; controlling the lifter to work to drive the pushing member to move in the third direction so that the pushing member is allowed to be in contact with the probe assembly; and controlling the first driving module to work to drive the lifter to move in the second direction so that the probe assembly is driven to move to a second preset position by means of the pushing member. In this way, with the matching between the first driving module and the lifter, the probe assembly is stably pushed to the second preset position, thereby effectively completing the range adjustment in the second direction.

The above description is only a summary of the technical solutions of the present application. In order to be able to understand the technical means of the present application more clearly, the technical means can be implemented according to the content of the specification. Furthermore, to make the above and other objectives, features and advantages of the present application more comprehensible, specific implementations of the present application are exemplified below.

### Description of Drawings

Various other advantages and benefits will become apparent to those of ordinary skill in the art upon reading the following detailed description of the preferred embodiments. The drawings are merely for the purpose of illustrating the preferred embodiments and are not construed as a limitation to the present application. Like reference numerals refer to like components throughout all the figures, In the accompanying drawings:
Fig. 1 is a schematic structural diagram of a testing apparatus according to some embodiments of the present application;
Fig. 2 is an exploded structural diagram of an inverted testing apparatus according to some embodiments of the present application;
Fig. 3 is a schematic structural diagram of a connection mechanism according to some embodiments of the present application;
Fig. 4 is a schematic diagram of a probe assembly fitted with a locking structure according to some embodiments of the present application;
Fig. 5 is an enlarged schematic diagram of the structure at part A in Fig. 2;
Fig. 6 is a schematic structural diagram I of a connection mechanism according to some embodiments of the present application;
Fig. 7 is a schematic structural diagram II of a moving mechanism according to some embodiments of the present application;
Fig. 8 is a partial schematic structural diagram of a testing apparatus according to some embodiments of the present application;
Fig. 9 is a schematic diagram of a wire arrangement structure fitted with a probe assembly according to some embodiments of the present application;
Fig. 10 is a flow chart I of a method of range adjustment for a testing apparatus according to some embodiments of the present application;
Fig. 11 is a flow chart II of a method of range adjustment for a testing apparatus according to some embodiments of the present application; and
Fig. 12 is a flow chart III of a method of range adjustment for a testing apparatus according to some embodiments of the present application.

100, testing apparatus; 10, moving mechanism; 11, second driving module; 12, mating device; 121, second driving member; 122, positioning member; 13, carrier; 14, slide carriage; 141, positioning hole; 142, via hole; 15, brake; 151, body; 152, elastic member; 153, brake end; 20, connection mechanism; 21, mount; 22, probe assembly; 221, connection seat; 222, probe body; 223, force receiving portion; 224, limiting protrusion; 225, through hole; 23, locking structure; 231, first driving member; 232, clamping member; 233, limiting slot; 30, adjustment mechanism; 31, first driving module; 32, pushing member; 33, lifter; 34, fixing beam; 40, wire arrangement structure; 41, sliding member; 42, carrying member; 43, guide wheel; 44, supporting member; 441, slide rail; 442, opening; 45, fixing plate; 46, lead hole; 47, wire harness; 471, bending section; 50, auxiliary mechanism; 51, third driving member; 52, fourth driving member; 53, auxiliary probe; 60, support seat; 70, casing; Y, first direction; X, second direction; and Z, third direction.

### Detailed Description of the Embodiments

Examples of the technical solutions of the present application will be described in detail below in conjunction with the drawings. The following embodiments are only used to more clearly illustrate the technical solution of the present application, and therefore are only used as examples and cannot be used to limit the scope of protection of the present invention. The scope of the invention is defined by the appended claims.

Unless otherwise defined, all technical and scientific terms used herein have the same meaning as commonly understood by those skilled in the art belonging to the technical field of the present application; the terms used herein are intended only for the purpose of describing specific examples and are not intended to limit the present application; the terms "including" and "having" and any variations thereof in the specification and the claims of the present application and in the description of drawings above are intended to cover non-exclusive inclusion.

In the description of the embodiments of the present application, the technical terms "first", "second", and the like are used only to distinguish between different objects, and are not to be understood as indicating or implying a relative importance or implicitly specifying the number, particular order, or primary and secondary relation of the technical features indicated. In the description of the embodiments of the present application, the meaning of "a plurality of" is two or more, unless otherwise explicitly and specifically defined.

Reference herein to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present application, the term "and/or" is only an association relationship for describing associated objects, indicating that there may be three relationships, for example A and/or B may represent three situations: A exists alone, both A and B exist, and B exists alone. In addition, the character "/" herein generally means that the associated objects before and after it are in an "or" relationship.

In the description of the embodiments of the present application, the term "a plurality of" refers to two or more (including two), and similarly, "multiple groups" refers to two or more (including two) groups, and "multiple sheets" refers to two or more (including two) sheets.

In the description of the embodiments of the present application, the orientation or position relationship indicated by the technical terms "center", "longitudinal", "transverse", "length", "width", "thickness", "upper," "lower," "front," "back," "left," "right," "vertical," "horizontal," "top," "bottom," "inner," "outer," "clockwise," "counterclockwise," "axial", "radial", "circumferential", etc. are based on the orientation or position relationship shown in the drawings and are intended to facilitate the description of the embodiments of the present application and simplify the description only, rather than indicating or implying that the device or element referred to must have a particular orientation or be constructed and operated in a particular orientation, and therefore are not to be interpreted as limitations on the embodiments of the present application.

In the description of the embodiments of the present application, unless otherwise expressly specified and limited, the technical terms "mount," "join," "connect," "fix," etc. should be understood in a broad sense, such as, a fixed connection, a detachable connection, or an integral connection; a mechanical connection, or an electrical connection; a direct connection, an indirect connection through an intermediate medium, an internal connection of two elements, or interaction between two elements. For those of ordinary skill in the art, the specific meanings of the above terms in the embodiments of the present application can be understood according to specific situations.

During preparation of a battery, the battery needs to be tested for various parameters to ensure that the battery product meets the delivery requirements, such as insulation testing and voltage testing. In insulation or conductivity testing, a probe testing apparatus is usually used, a probe is used to make contact with an electrode terminal of the battery, such as a terminal post, so that the electrode terminal is indirectly connected to the testing device to complete a testing operation.

The applicant notes that with the diversification of battery designs, batteries are available in different sizes and dimensions. When the probe is applied to batteries in different specifications, reasonable range adjustment is required for allowing the probe to make accurate contact with the electrode terminal. When performing range adjustment on a conventional probe testing apparatus, a jackscrew in a middle hole of each of four sliders needs to be loosened manually first, each probe plate is moved manually to the corresponding position, and then the jackscrew is locked, in order to achieve compatibility with the testing of batteries in different specifications.

However, this manual range adjustment method requires a lot of manpower and is time-consuming and laborious. Moreover, the difference in manual experience and the fatigue caused by long-term operation and other factors may cause large errors in range adjustment of the probe during operation, and make it impossible to accurately position the probe on the electrode assembly, resulting in low reliability of the testing result.

Based on this, after intensive research, the applicant designs a testing apparatus for improving the testing efficiency, meeting the battery production takt, and improving the range adjustment accuracy. By means of a moving mechanism, a mount is driven to move in a first direction. Next, a probe assembly is movably arranged on the mount in a second direction; by means of an adjustment mechanism, the probe assembly is driven on the mount in the second direction to achieve the adjustment in the second direction.

The moving mechanism and the adjustment mechanism are integrated in use in such a way, so that the probe assembly is driven directly or indirectly to achieve automatic adjustment in at least two dimensions. Compared with a traditional probe testing apparatus, the testing apparatus has the advantages of saving time and effort, improving the testing efficiency and meeting the battery production takt, and also reducing manual operation errors and effectively improving the range adjustment accuracy of the probe assembly.

The battery to which the testing apparatus provided in the present application is applicable has various forms, for example, the battery may be in the form of a battery cell, or in the form of a battery module; alternatively, the battery may be in the form of a battery pack. In a case that the battery is a battery cell, the electrode terminal may be a terminal post on the battery cell.

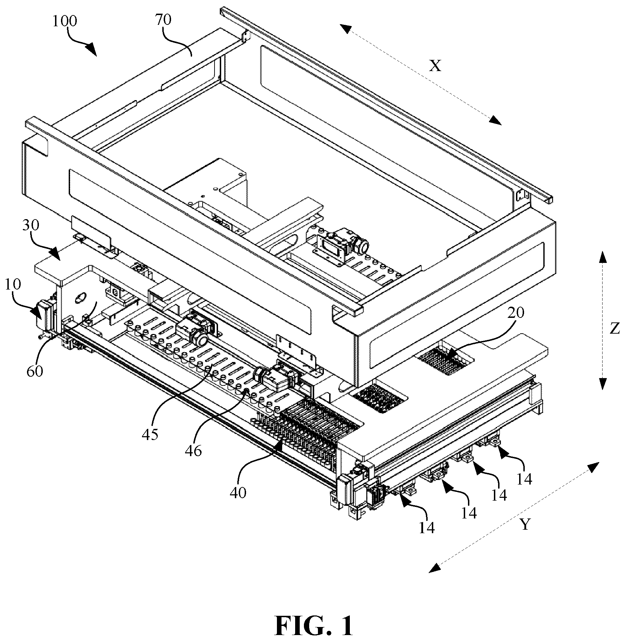

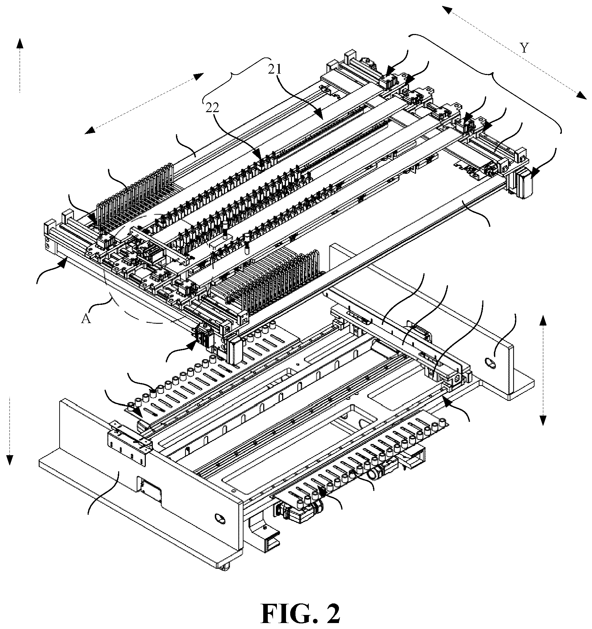

According to the present invention, with reference to Figs. 1 and 2, the present application provides a testing apparatus 100. The testing apparatus 100 includes a moving mechanism 10, a connection mechanism 20 and an adjustment mechanism 30. The connection mechanism 20 includes a mount 21 and a probe assembly 22 movably disposed on the mount 21. The mount 21 is disposed on the moving mechanism 10 and moved in a first direction Y under the action of the moving mechanism 10. The probe assembly 22 is configured to make electrical contact with a part to be tested. The adjustment mechanism 30 is configured to drive the probe assembly 22 in a second direction X, the first direction Y intersecting the second direction X.

The moving mechanism 10 is a device capable of driving the connection mechanism 20 to move in the first direction Y, which may be designed as a cylinder, a hydraulic cylinder, an electric cylinder, or the like, and may also be designed as a linear module or a combination structure of a motor and a transmission mechanism, and the like, for example, a combination structure of a motor and a gear and rack, and a combination structure of a motor and a roller and belt.

The connection mechanism 20 refers to a component that enables an indirectly electrical connection between the part to be tested and an external testing device. After the probe assembly 22 is adjusted in the first direction Y and/or the second direction X, one end of the probe assembly 22 is in electrical contact with the part to be tested and the other end is electrically connected to the external testing device, so that the part to be tested and the testing device are electrically connected. For the testing device, there are different options depending on testing parameters, for example, it may be, but is not limited to, an insulation resistance tester. In addition, in a battery testing process, the part to be tested may be a battery. Further, the battery there may be a battery module, or a structure such as a battery pack or a battery cell.

The probe assembly 22 is in electrical contact with the part to be tested, which may be in contact with the electrode terminal of the part to be tested, for example, one end of the probe assembly 22 is in electrical contact with the terminal post on the battery cell. There are various ways of electrical contact between the probe assembly 22 and the electrode terminal, for example, the range-adjusted probe assembly 22 is driven by a device such as a cylinder, a hydraulic cylinder or an electric cylinder to be crimped onto the electrode terminal.

The probe assembly 22 is of a movable design on the mount 21 and is moved in the second direction X under the action of the adjustment mechanism 30. There are various designs for the movable installation of the probe assembly 22. For example, a guide rail and a slider structure are arranged between the probe assembly 22 and the mount 21; alternatively, a roller structure is arranged between the probe assembly 22 and the mount 21, or the like.

The adjustment mechanism 30 refers to a device capable of driving the probe assembly 22 to move on the mount 21, which may be designed as a cylinder, a hydraulic cylinder, an electric cylinder or other devices having a telescoping function, and may also be designed as a linear module or a combination structure of a motor and a transmission mechanism.

The first direction Y is a direction in which the mount 21 is moved under the action of the moving mechanism 10, and the second direction X is a direction in which the probe assembly 22 moves on the mount 21, and the two directions intersect, indicating that the probe assembly 22 can move in at least two dimensions. Specifically in some embodiments, the first direction Y and the second direction X may be perpendicular to each other.

This design combines the moving mechanism 10 and the adjustment mechanism 30 to drive the probe assembly 22 directly or indirectly to achieve automatic adjustment in at least two dimensions, thereby saving time and effort, improving the testing efficiency and meeting the production takt, and also reducing manual operation errors and effectively improving the range adjustment accuracy of the probe assembly 22.

According to some embodiments of the present application, reference is made to Fig. 2, Fig. 2 is an exploded structural diagram of an inverted testing apparatus structure according to some embodiments of the present application. The upper side and the lower side in Fig. 2 are identified for ease of understanding the placement of the testing apparatus 100 in Fig. 2. The adjustment mechanism 30 includes a first driving module 31 and a pushing member 32. The first driving module 31 is configured to drive the pushing member 32 to move in the second direction X until it abuts against the probe assembly 22 and to push the probe assembly 22.

The first driving module 31 refers to a power source that enables the pushing member 32 to move in the second direction X, which may be designed as a linear module, or as a cylinder, a hydraulic cylinder or other devices; or may be designed as a combination structure of a motor and a transmission mechanism, or the like.

The pushing member 32 is a component capable of driving the probe assembly 22 under the driving of the first driving module 31. The pushing member 32 may be spaced apart from the probe assembly 22 in the second direction X before it comes to contact with the probe assembly 22. **In** this case, the pushing member 32 is driven by the first driving module 31 to move towards and abut against the probe assembly 22. Of course, before range adjustment in the second direction X, the pushing member 32 can be located outside the connection mechanism 20, for example, the pushing member 32 can be located above, below or on one side of the probe assembly 22. In this case, the pushing member 32 needs to move to one side of the probe assembly 22 and projects at least partially in the second direction X onto the probe assembly 22, so that the pushing member 32 can abut against the probe assembly 22 as it moves in the second direction X.

**In** addition, when the pushing member 32 is located above or below the probe assembly 22 before the range adjustment, the pushing member 32 may be inserted into the connection mechanism 20 by lifting, and may also be rotated into the connection mechanism 20, or the like.

The first driving module 31 is used to drive the pushing member 32 to move in the second direction X to push the probe assembly 22 to move in the second direction X, achieving effective adjustment of the probe assembly 22 in the second direction.

According to some embodiments of the present application, referring to Fig. 2, the adjustment mechanism 30 further includes a lifter 33 connected to the pushing member 32. The first driving module 31 is spaced apart from the connection mechanism 20 in the third direction Z and is configured to drive the lifter 33 in the second direction X. The lifter 33 is configured to drive the pushing member 32 in the third direction Z. The third direction Z is perpendicular to the first direction Y and the second direction X, respectively.

The first driving module 31 and the connection mechanism 20 are spaced apart in the third direction Z. This means that the pushing member 32 can be inserted into the connection mechanism 20 as the pushing member 32 moves in the third direction Z, which allows the pushing member 32 to abut against the probe assembly 22 when moving in the second direction X. Of course, after the range adjustment in the second direction X is completed, the pushing member 32 may be moved in an opposite direction of the third direction Z to be separated from the connection mechanism 20, thus leaving operation room for the connection mechanism 20 and reducing structural interference. Specifically in some embodiments, the third direction Z is a vertical direction and the first driving module 31 is located above the connection mechanism 20. Moreover, in order to stabilize the spacing between the first driving module 31 and the connection mechanism 20, two support seats 60 are provided at an interval in the second direction X. The first driving module 31 and the moving mechanism 10 are arranged on the support seats 60 at an interval in the third direction Z, and the connection mechanism 20 is arranged on the moving mechanism 10.

The lifter 33 is a device capable of driving the pushing member 32 to move in the third direction Z, which may be designed as a cylinder, an electric cylinder, a hydraulic cylinder, or the like, and may also be designed as a combination structure of a motor and a transmission mechanism. For example, the motor drives a rack to move in the third direction Z through gears.

The first driving module 31 drives the lifter 33 to move in the second direction X, which has two functions as below. Firstly, the pushing member 32 can be driven to move to the space of one side of the pushing member 32, so that the pushing member 32 can extend into the connection mechanism 20 under the action of the lifter 33, for example, the same mount 21 is provided with a plurality of probe assemblies 22, all the probe assemblies 22 are disposed apart on the mount 21 in the second direction X. **In** this case, the pushing member 32 may be moved to the upper side between two adjacent probe assemblies 22, and the like. Secondly, the pushing member 32 is driven to move to push the probe assemblies 22.

To facilitate driving the lifter 33 through the first driving modules 31, two first driving modules 31 are provided. A fixing beam 34 is slidably arranged on the two first driving modules 31, and the lifter 33 is mounted on the fixing beam 34. A structure such as a rail and a slider may be arranged between the fixing beam 34 and the first driving modules 31.

In a case that there are a plurality of connection mechanisms 20, all of the connection mechanisms 20 are arranged at intervals in the first direction Y. The pushing member 32 may be arranged in the first direction Y. In this case, the pushing member 32 can push the probe assembly 22 in the same row in the first direction Y, so that the probe assemblies 22 in different connection mechanisms 20 are adjusted simultaneously in the second direction X.

In addition, in order to help the pushing member 32 to push the probe assembly 22, the probe assembly 22 includes a connection seat 221 and a probe body 222 and a force receiving portion 223 that are disposed on the connection seat 221. The connection seat 221 is movably disposed on the mount 21. The probe body 222 and the force receiving portion 223 are both located on the same side of the mount 21 in the first direction Y. The force receiving portion 223 protrudes from the mount 21 in the third direction Z. With this design, the pushing member 32 acts on the force receiving portion 223 better, effectively driving the probe body 222 and the connection seat 221 to move in the second direction X.

The lifter 33 is provided to drive the pushing member 32 in the third direction Z, so that the pushing member 32 is allowed to extend into the connection mechanism 20, thus enabling the pushing member 32 to act better on the probe assembly 22 and achieving effective range adjustment.

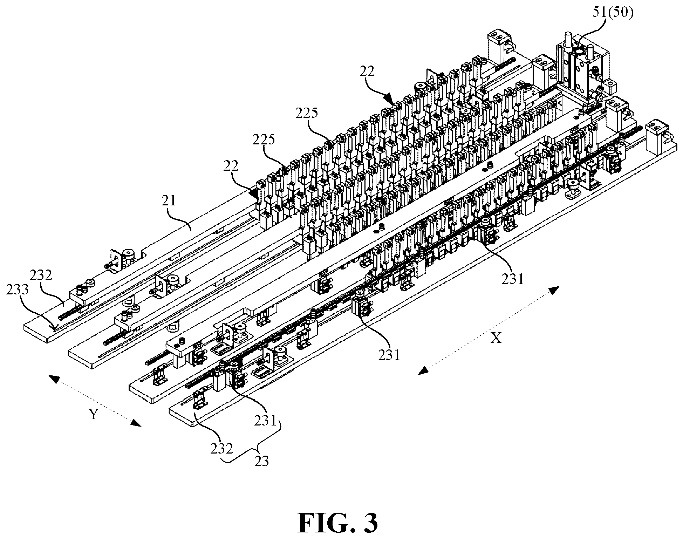

According to some embodiments of the present application, referring to Fig. 3, the connection mechanism 20 further includes a locking structure 23. The locking structure 23 is configured to lock the range-adjusted probe assembly 22, so as to restrict the probe assembly 22 from moving in the second direction X.

The locking structure 23 is a structure capable of locking the probe assembly 22 to restrict it from continuing to move in the second direction X after the range adjustment of the probe assembly 22 in the second direction X is complete. The locking structure 23 may be designed as a gripping structure, or as a pin mechanism, or the like.

The locking structure 23 is used to lock the probe assembly 22 so that the probe assembly 22 does not continue to move in the second direction X, the probe assembly 22 is allowed to make stable contact with the part to be tested, which is conducive to improving the testing stability.

According to some embodiments of the present application, referring to Fig. 3, the locking structure 23 includes a clamping member 232 and a first driving member 231 disposed on the mount 21. The probe assembly 22 is at least partially located between the clamping member 232 and the mount 21, and the first driving member 231 is configured to drive the clamping member 232 to move, so as to clamp or release the probe assembly 22.

The first driving member 231 is a device capable of driving the clamping member 232 to move close to or away from the mount 21, for example, it may be, but is not limited to, a cylinder, a hydraulic cylinder, an electric cylinder, and the like. When the first driving member 231 drives the clamping member 232 to move close to the mount 21, a clamping force is formed between the clamping member 232 and the mount 21 on the probe assembly 22, restricting the probe assembly 22 from continuing to move **in** the second direction X.

The portion of the probe assembly 22 disposed between the clamping member 232 and the mount 21 may be the connection seat 221 proposed in the above embodiment, that is, the connection seat 221 is partially disposed between the clamping member 232 and the mount 21. The clamping member 232 can clamp the connection seat 221 when moving close to the mount 21 so as to restrict the probe assembly 22 from moving.

The locking structure 23 is designed as the first driving member 231 and the clamping member 232, so that the probe assembly 22 is restricted to the mount 21 in a clamping manner, facilitating a locking operation of the probe assembly 22.

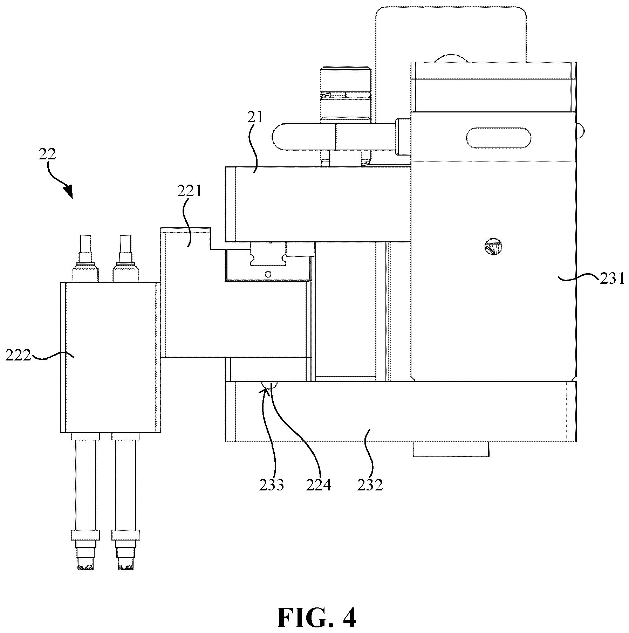

According to some embodiments of the present application, referring to Figs. 3 and 4, the clamping member 232 is provided with a limiting slot 233 extending in the second direction X, the probe assembly 22 is provided with a limiting protrusion 224, and a slot wall of the limiting slot 233 is allowed to abut against or be separated from the limiting protrusion 224 when driven by the first driving member 231.

The limiting slot 233 is the space formed by an internal recess in the clamping member 232. When the clamping member 232 is driven by the first driving member 231 to move close to the probe assembly 22, the limiting protrusion 224 abuts against a wall of the limiting slot 233, so that the movement of the probe assembly 22 is locked. When the clamping member 232 is driven by the first driving member 231 to move away from the probe assembly 22, there is a gap between the limiting protrusion 224 and the limiting slot 233, which may function in guiding, making the probe assembly 22 move more smoothly.

The limiting protrusion 224 is a structure protruding outwards on the probe assembly 22, which may be integrated with the probe assembly 22 or a combination structure. For example, referring to Fig. 4, the limiting protrusion 224 may be a ball plunger, the ball plunger being embedded in the probe assembly 22.

The matching between the limiting protrusion 224 and the limiting slot 233 can not only improve the smoothness in movement of the probe assembly 22, but also lock the movement of the probe assembly 22, so that the probe assembly 22 acts accurately on the part to be tested.

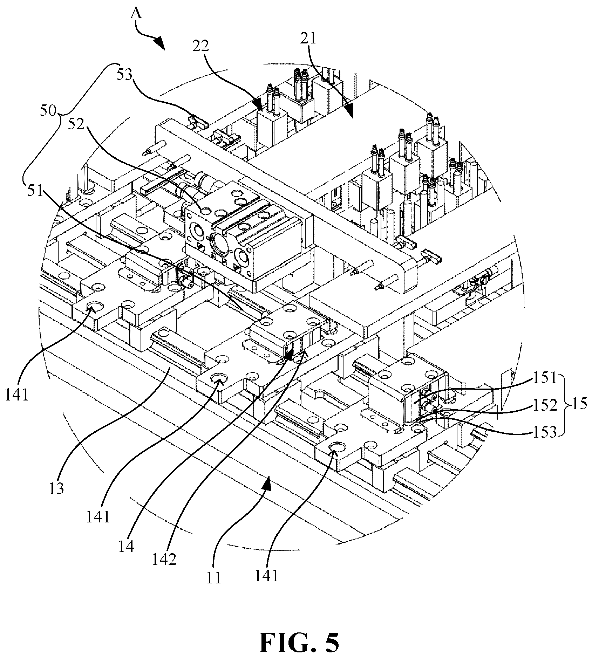

According to some embodiments of the present application, referring to Fig. 5, the moving mechanism 10 includes a second driving module 11 and a mating device 12 and a carrier 13 that are disposed on the second driving module 11. The mount 21 is movably disposed on the carrier 13 in the first direction Y. The second driving module 11 is configured to drive the mating device 12 in the first direction Y. The mating device 12 is configured to be mated or unmated with the mount 21.

The second driving module 11 is a power source that enables the mating device 12 to move in the first direction Y, which may be designed as a linear module, or as a cylinder, a hydraulic cylinder or other devices, or may also be designed as a combination structure of a motor and a transmission mechanism.

The mating device 12 is a component mated or unmated with the mount 21. When the second driving module 11 drives the mating device 12 to move to the mount 21, the mating device 12 may be mated with the mount 21; after mating, when the second driving module 11 drives the mating device 12 to continue to move, the mount 21 also moves, so as to realize the range adjustment operation in the first direction Y.

The mating between the mating device 12 and the mount 21 may be direct mating or indirect mating. The indirect mating means that an intermediate structure is arranged on the mount 21 and the mating device 12 is mated with the mount 21 through the intermediate structure.

In a case that there are a plurality of connection mechanisms 20 and all the mounts 21 are spaced apart in the first direction Y, the mating device 12 may be selectively mated with one of the mounts 21 under the driving of the second driving module 11, so that one of the mounts 21 can be targeted for range adjustment.

The carrier 13 is a carrier structure for moving of the mount 21. Although both the carrier 13 and the mating device 12 are arranged on the second driving module 11, the carrier 13 is not affected by the driving of the second driving module 11 and remains fixed on the second driving module 11. For example, the mating device 12 is arranged on an output end of the second driving module 11, and the carrier 13 is arranged on a housing of the second driving module 11. It is not difficult to understand that the carrier 13 may also be arranged extending in the first direction Y.

Under the action of the second driving module 11, the mating device 12 is allowed to be mated with the mount 21 in the first direction to move the mount 21 to a desired position, thus achieving effective range adjustment in the first direction Y.

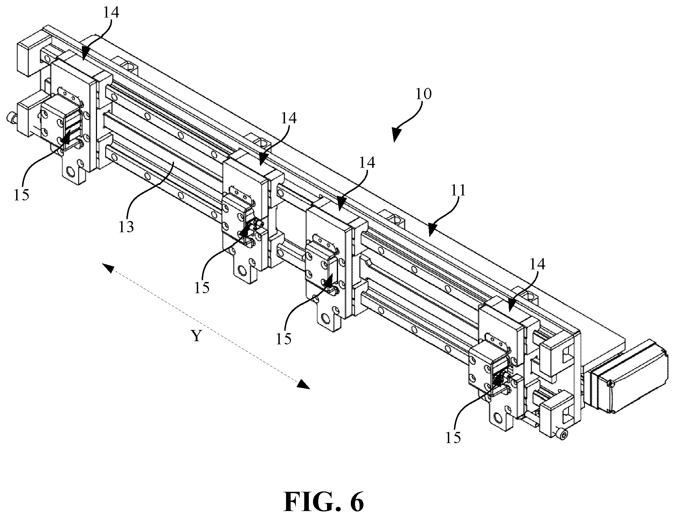

According to some embodiments of the present application, referring to Figs. 5 and 6, the moving mechanism 10 further includes a slide carriage 14 that moves in the first direction Y on the carrier 13. The mount 21 is disposed on the slide carriage 14, and the mating device 12 is configured to be mated or unmated with the mount 21 via the slide carriage 14.

The slide carriage 14 is a structure capable of moving in the first Y direction on the carrier 13 and is an intermediate structure for achieving the indirect mating between the mating device 12 and the mount 21. When the mating device 12 is moved to the slide carriage 14, it is mated with the slide carriage 14 so that the mating device 12, the slide carriage 14 and the mount 21 form an integrated structure.

In case that there are a plurality of mounts 21, a plurality of slide carriages 14 may be provided. Moreover, if the slide carriages 14 and the mounts 21 are configured one to one in number, the mating device 12 may be selectively mated with one of the slide carriages 14, achieving adjustment on the position of one of the mounts 21.

There are various methods of mating the mating device 12 and the slide carriage 14, which may be, for example, but is not limited to, plugging, electromagnetic adsorption, clamping, and the like. Moreover, there are various methods of mounting the mount 21 and the slide carriage 14, which may be, for example, but is not limited to, bolting, snap-fit, riveting, welding, gluing, and the like.

Since the slide carriage 14 is movably arranged on the carrier 13, the mount 21 is moved more stably, which is conducive to improving the range adjustment accuracy, and also facilitates the mating between the mating device 12 and the mount 21, thus improving convenience in the range adjustment operation.

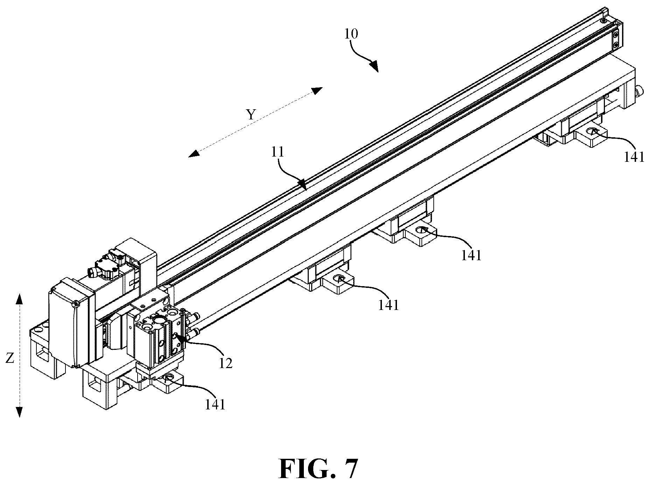

According to some embodiments of the present application, referring to Figs. 5 and 7, the mating device 12 includes a second driving member 121 and a positioning member 122 driven to extend or retract by the second driving member 121. The slide carriage 14 is provided with a positioning hole 141 for insertion of the positioning member 122.

The second driving member 121 is a device capable of driving the positioning member 122 to extend or retract, for example, which may be, but is not limited to, a cylinder, a hydraulic cylinder, an electric cylinder, and the like. When the first driving member 231 drives the positioning member 122 to extend out, the positioning member 122 can be inserted into the positioning hole 141, so that the mating device 12 and the slide carriage 14 are connected. When the range adjustment in the first direction Y is completed, the first driving member 231 drives the positioning member 122 to retract, and the positioning member 122 exits the positioning hole 141, causing the mating device 12 and the slide carriage 14 to be separated. Specifically, in some embodiments, the second driving member 121 and the positioning hole 141 are spaced apart in the third direction Z. For example, the second driving member 121 is located above the positioning hole 141 so that when the second driving member 121 moves directly above the positioning hole 141, the positioning member 122 is driven to extend out to be inserted into the positioning hole 141.

The matching between the positioning member 122 and the positioning hole 141 allows for a quick connection and disconnection between the mating device 12 and the slide carriage 14, thereby improving the range adjustment efficiency.

According to some embodiments of the present application, referring to Fig. 6, the moving mechanism 10 further includes a brake 15. The brake 15 is disposed on the slide carriage 14 to restrict the slide carriage 14 from moving in the first direction Y.

The brake 15 is a component that restricts the slide carriage 14 from continuing to move in the first direction Y on the carrier 13. When a positioning member moves with the slide carriage 14 to a desired position, the brake 15 works to brake the slide carriage 14 so that the mount 21 stays stable in the desired position.

There are various ways in which the brake 15 brakes the slide carriage 14. For example, the brake may be applied to the slide carriage 14 by, but not limited to, holding, clamping, clamping, abutting, and the like. Specifically in some embodiments, the brake 15 has a retractable brake end 153, the slide carriage 14 is provided with a via hole 142, and the brake end 153 of the brake 15 penetrates the via hole 142. When the brake end 153 abuts against the carrier 13 under the action of the brake 15, the slide carriage 14 is effectively braked on the carrier 13. Moreover, the brake 15 includes a body 151 and an elastic member 152 (e.g. a spring) sleeved between the body 151 and the brake end 153. The brake end 153 is popped out by the elasticity of the elastic member 152 to abut against the carrier 13. The body 151 is used to drive the brake end 153 to retract to be disengaged from the carrier 13. The body 151 may be a cylinder, a hydraulic cylinder, or the like.

The brake 15 is applied to restrict the slide carriage 14 from continuing to move in the first direction Y so that it stays steadily in a desired position, thereby improving the range adjustment accuracy and facilitating improvement of the reliability of the testing results.

According to some embodiments of the present application, referring to Figs. 5 and 7, there are at least two connection mechanisms 20. Mounts 21 of all the connection mechanisms 20 are spaced apart in the first direction, and the mating device 12 is allowed to be selectively mated to one of the mounts 21 under the action of the second driving module 11.

The mating device 12 is selectively mated with one of the mounts 21 under the action of the second driving module 11, and the mating device 12 and the mount 21 form an integral structure, thus the mating device 12 can move the mount 21 in the first direction Y.

With such a design, range adjustment of one of the mounts 21 in the first direction Y can be achieved selectively, so that the testing apparatus 100 can meet requirements for the testing of parts to be tested (e.g. batteries) in more specifications, and the range of application of the testing apparatus is expanded.

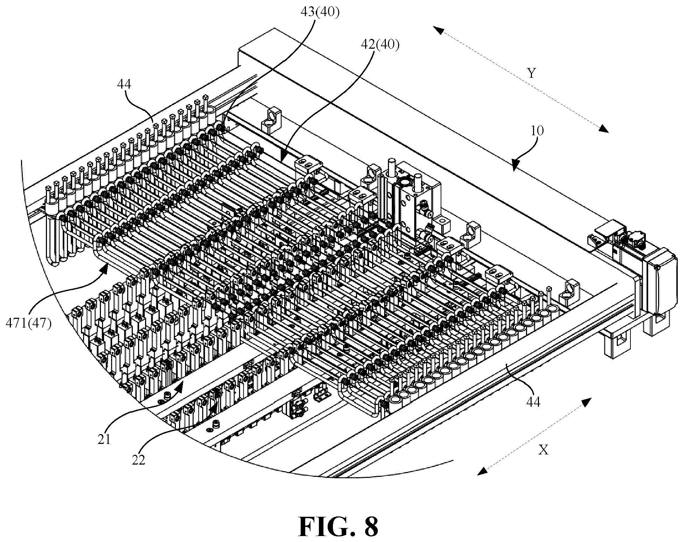

According to the present invention, referring to Fig. 8, the connection mechanism 20 further includes a wire arrangement structure 40 and a wire harness 47. The wire arrangement structure 40 extends in the first direction Y and is capable of moving in the second direction X, the wire harness 47 is wound on the wire arrangement structure 40 and electrically connected to the probe assembly 22, and the wire harness 47 on at least one side of the probe assembly 22 in the first direction X has a bending section 471.

The wire arrangement structure 40 is a structure that supports the wire harness 47. The wire arrangement structure 40 can move in the second direction X so as to maintain synchronous movement with the probe assembly 22 during range adjustment in the second direction X. In this way, the chance of the wire harness 47 being broke due to pulling when the probe assembly 22 moves in the second direction X can be reduced.

When the probe assembly 22 is moved in the second direction X, the wire arrangement structure 40 may be moved with the probe assembly 22. For example, the wire arrangement structure 40 is connected to the probe assembly 22 while extending in the first direction Y. Of course, the wire arrangement structure 40 may also be moved under the driving of the adjustment mechanism 30. For example, a portion of the pushing member 32 of the adjustment mechanism 30 also abuts against the wire arrangement structure 40.

The bending section 471 is a section of the wire harness 47 that in bending, which may also be understood as a redundant section of the wire harness 47 wound on the wire arrangement structure 40. When the mount 21 moves the probe assembly 22 in the first direction Y, the bending section 471 is stretched so that breaking of the wire harness 47 due to pulling when the probe assembly 22 is moved in the first direction is avoided.

One side of the probe assembly 22 in the first direction Y may be provided with the bending section 471. Alternatively, both sides of the probe assembly 22 in the first direction Y may be provided with bending sections 471. Moreover, on one side of the probe assembly 22, one or more bending sections 471 may be provided.

The wire arrangement structure 40 is designed to be capable of moving in the second direction X, so that the wire arrangement structure 40 keeps moving simultaneously with the probe assembly 22 in the second direction X, reducing the risk of disconnection due to the probe assembly 22 moving in the second direction; and moreover, since the wire harness 47 is wound on the wire arrangement structure 40 by means of the bending section 471, the risk of wire breakage due to the probe assembly 22 moving in the first direction is reduced.

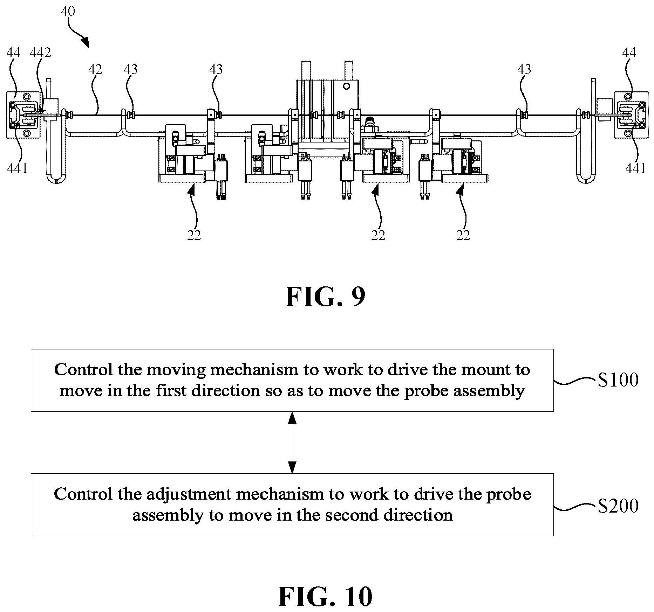

According to the present invention, referring to Figs. 8 and 9, the moving mechanism 10 is provided with two supporting members 44 spaced apart in the first direction Y. The wire arrangement structure 40 includes two sliding members 41 and a carrying member 42 connected between the two sliding members 41, the sliding members 41 are slidably disposed on the corresponding supporting member 44 in the second direction X, and the wire harness 47 is wound on the carrying member 42.

The supporting member 44 is a structure that supports the sliding member 41 and allows the sliding member 41 to move in the second direction X. In a case that there are two moving mechanisms 10 and the two moving mechanisms 10 are spaced apart in the second direction X, the supporting members 44 are each connected between the two moving mechanisms 10.

The sliding member 41 is capable of moving in the second direction X on the supporting member 44, which may be implemented in various ways. For example, the supporting member 44 is provided with a guide rail extending in the second direction X, and the sliding member 41 is disposed on the guide rail. Alternatively, referring to Fig. 9, a slide rail 441 extending in the second direction X is disposed in the supporting member 44, and the supporting member 44 is provided with an opening 442 communicating with the slide rail 441, the sliding member 41 is located in the slide rail 441, and the carrying member 42 is connected to the sliding member 41 via the opening 442, and the like. The sliding member 41 may be a roller structure in order to make the sliding process smoother.

The carrying member 42 is a structure capable of supporting the wire harness 47, which may be, for example, but is not limited to, a steel wire, a stay, and the like. The carrying member 42 may be connected to the probe assembly 22, or may not be connected to the probe assembly 22. When the carrying member 42 is not connected to the probe assembly 22, the adjustment mechanism 30 drives the carrying member 42 or sliding member 41 to move while driving the probe assembly 22 to move in the second direction X. When the carrying member 42 is connected to the probe assembly 22, the carrying member 42 may be moved with the probe assembly 22 moving in the second direction X. In this case, it should be noted that the carrying member 42 and the probe assembly 22 are connected in a manner that should not affect the probe assembly 22 moving in the first direction Y. For example, the probe assembly 22 is provided with a through hole 225 extending in the first direction Y, and the carrying member 42 penetrates the through hole 225, so that the synchronous movement in the second direction X is enabled, and the carrying member 42 does not affect the movement of the probe assembly 22 in the first direction Y.

The wire arrangement structure 40 is designed as the sliding members 41 and the carrying member 42, so that the wire arrangement structure 40 can move synchronously with the probe assembly 22 in the second direction, and moreover, the wire harness 47 is allowed to be carried steadily, making it unnecessary to arrange the wire harness 47 during range adjustment.

According to some embodiments of the present application, referring to Fig. 9, the wire arrangement structure 40 further includes a guide wheel 43. The guide wheel 43 sleeves the carrying member 42, and the wire harness 47 is wound on the guide wheel 43.

When the probe assembly 22 moves with the mount 21 in the first direction Y, the wire harness 47 is pulled to move on the carrying member 42. According to the present application, the guide wheel 43 sleeves the carrying member 42, and moving of the wire harness 47 on the carrying member 42 by friction directly is replaced by rolling of the guide wheel 43, which is conducive to reducing the wear of the wire harness 47.

The number of guide wheels 43 may be one or more. In a case that there are a plurality of guide wheels 43, all the guide wheels 43 are spaced apart on the carrying member 42 in the first direction Y. In this case, the wire harness 47 is wound around the guide wheels 43 in sequence, and the bending section of the wire harness 47 is between two adjacent guide wheels 43.

According to the present invention, to make the wire harness 47 more regular, a fixing plate 45 is provided. The fixing plate 45 is provided with lead holes 46, the wire harness 47 passes through the lead holes 46 and is wound on the carrying member 42. Moreover, two fixing plates 45 may be provided. The two fixing plates 45 are respectively located on opposite sides of the connection mechanism 20 in the first direction Y.

With such a design, the wear of the wire harness 47 as it moves on the carrying member 42 can be reduced by means of the guide wheels 43, which is conducive to prolonging service life of the wire harness 47.

According to some embodiments of the present application, referring to Fig. 5, the testing apparatus 100 further includes an auxiliary mechanism 50. A testing end of the auxiliary mechanism 50 is configured to make contact with a shell of the part to be tested.

The auxiliary mechanism 50 is a component capable of performing a specific test on the shell of the part to be tested. For example, when the shell of the battery needs to be tested for conduction performance, the auxiliary mechanism 50 is allowed to be in contact with the shell; an external testing device is then electrically connected to the auxiliary mechanism 50 and a positive terminal of the battery respectively so as to form a testing circuit, thus facilitating observation of the conduction performance of the shell of the battery. The external testing device may be an external power supply, an ammeter, or the like. Of course, during conduction performance testing, the probe assembly 22 and the auxiliary mechanism 50 may also be used with each other, with the probe assembly 22 abutting against the positive terminal of the battery and the auxiliary mechanism 50 being in contact with the shell of the battery.

Moreover, there are various designs for the mounting position of the auxiliary mechanism 50 in the testing apparatus 100, and the auxiliary mechanism may be reasonably distributed according to the internal structure of the testing apparatus 100. For example, the auxiliary mechanism 50 is arranged on the connection mechanism 20 or the moving mechanism 10 and capable of moving in the first direction Y; or, the auxiliary mechanism 50 is arranged on a casing 70 of the testing apparatus 100; or, a supporting structure is arranged inside the testing apparatus 100, and the auxiliary mechanism 50 is fixed onto the supporting structure, or the like. The casing 70 of the testing apparatus 100 refers to a structure that covers the moving mechanism 10, the connection mechanism 20 and the adjustment mechanism 30 in order to protect the internal structure.

In order to facilitate contact of the auxiliary mechanism 50 on the shell of the part to be tested, the auxiliary mechanism 50 may include a third driving member 51, a fourth driving member 52 and an auxiliary probe 53. The auxiliary probe 53 is arranged at a driving end of the fourth driving member 52, the fourth driving member 52 is arranged at a driving end of the third driving member 51, and a driving direction of the third driving member 51 intersects with a driving direction of the third driving member 51. In an actual operation, the driving direction of the third driving member 51 may be aligned with the third direction Z, that is, the third driving member 51 drives the fourth driving member 52 to move up and down. When the fourth driving member 52 is lowered to a certain height, the fourth driving member 52 drives the auxiliary probe 53 towards the shell of the battery, so that the auxiliary probe 53 is allowed to make contact with the shell.

When the part to be tested is a battery, the shell of the battery has various structural forms. For example, when the battery is a battery cell, the shell is a housing for accommodating the electrode assembly; when the battery is a battery module, the shell may be an end plate structure, or the like.

With the auxiliary mechanism 50, other specific test requirements on the part to be tested can be met, which is conducive to improving testing functions of the testing apparatus 100.

According to the present invention, referring to Fig. 10, the present application provides a method of range adjustment for a testing apparatus, which is applied to the above testing apparatus 100, and includes the steps as follows.

S100. Control the moving mechanism 10 to work to drive the mount 21 to move in the first direction Y so as to move the probe assembly 22.

S200. Control the adjustment mechanism 30 to work to drive the probe assembly 22 to move in the second direction X.

The order of performing the steps S100 and S200 is not limited, either step S100 or step S200 can be performed in priority or, of course, step S100 and step S200 can be performed simultaneously.

In this way, by the adjustment steps in which the moving mechanism 10 and the adjustment mechanism 30 are integrated in use, automatic adjustment in at least two dimensions is achieved. Compared with the traditional probe testing apparatus, the testing apparatus has the advantages of saving time and effort, improving the testing efficiency and meeting the production takt; and reducing manual operation errors and effectively improving the range adjustment accuracy of the probe assembly 22.

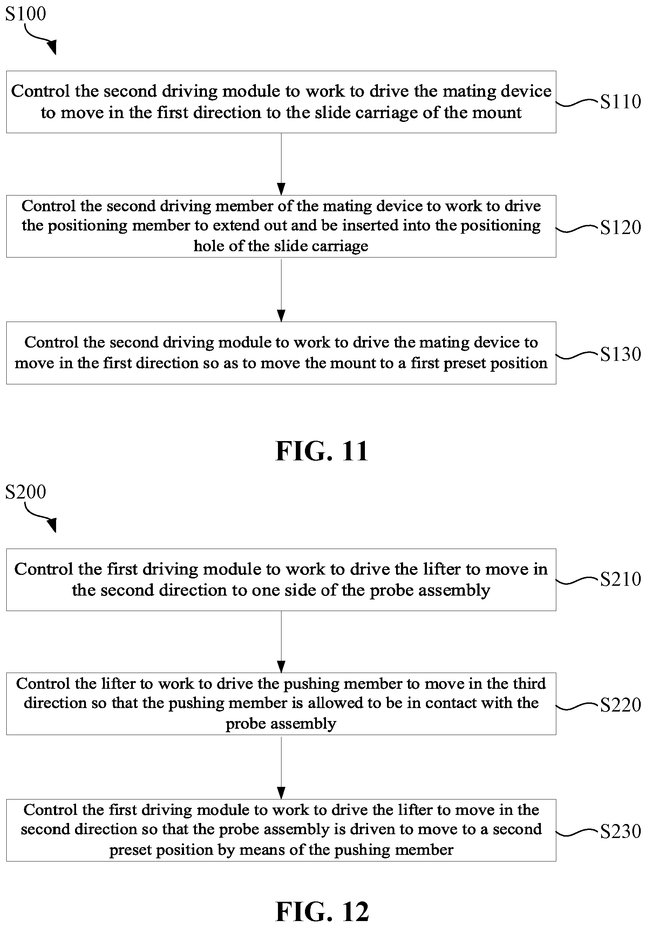

According to some embodiments of the present application, referring to Fig. 11, the step S100 of controlling the moving mechanism 10 to work to drive the mount 21 to move in the first direction Y includes the following.

S110. Control the second driving module 11 to work to drive the mating device 12 to move in the first direction Y to the slide carriage 14 of the mount 21.

S120. Control the second driving member 121 of the mating device 12 to work to drive the positioning member 122 to extend out and be inserted into the positioning hole 141 of the slide carriage 14.

S130. Control the second driving module 11 to work to drive the mating device 12 to move in the first direction Y so as to move the mount 21 to a first preset position.

In step S110, that the mating device 12 is moved in the first direction Y to the slide carriage 14 of the mount 21 should be understood as: the mating device 12 is moved to a position where it can be mated with the slide carriage 14.This position may, of course, have various options in actual design, for example, it may be located directly right below the slide carriage 14; it may also be located under the slide carriage 14 at an angle, where an extending path of the positioning member 122 should be a slant path, and the like.

The first preset position refers to a position to which the mount 21 moves the probe assembly 22. In this case, the probe assembly 22 is located at the position in a straight line in the second direction X with a point to be tested t on the part to be tested in the second direction X. This helps the adjustment mechanism 30 to drive the probe assembly 22 to move in the second direction X to be opposite to the point to be tested on the part to be tested. Of course, the first preset position may also be directly opposite the point to be tested on the part to be tested, that is, the range adjustment in the second direction X is performed preferably. In this case, the part to be tested may be a battery, or the like.

The mount 21 may also be locked when the mount 21 is moved to the first preset position. For example, the brake 15 is controlled to work to brake the mount 21.

The second driving module 11 and the mating device 12 are used together so that the mount 21 moves steadily to the first preset position by being mated or unmated with the mating device 12, thereby effectively completing the range adjustment in the first direction Y.

According to some embodiments of the present application, referring to Fig. 12, the step S200 of controlling the adjustment mechanism 30 to work to drive the probe assembly 22 to move in the second direction X includes the following.

S210. Control the first driving module 31 to work to drive the lifter 33 to move in the second direction X to one side of the probe assembly 22.

S220. Control the lifter 33 to work to drive the pushing member 32 in the third direction Z so that the pushing member 32 is allowed to be in contact with the probe assembly 22.

S230. Control the first driving module 31 to work to drive the lifter 33 to move in the second direction X so that the probe assembly 22 is driven to move to a second preset position by means of the pushing member 32.

In step S210, that the lifter 33 moves in the second direction X to one side of the probe assembly 22 should be understood as: the lifter 33 moves to a position that enables the pushing member 32 to be inserted into the connection mechanism 20 without structural interference with the probe assembly 22.

The second preset position refers to a position at which the pushing member 32 moves the probe assembly 22. In this case, the probe assembly 22 is located at the position in a straight line in the first direction Y with a point to be tested on the part to be tested, so that, in subsequent process, the moving mechanism 10 can drive the probe assembly 22 to move in the first direction Y to be opposite to the point to be tested on the part to be tested. Of course, the second preset position may also be directly opposite to the point to be tested on the part to be tested, that is, the range adjustment in the first direction Y is performed first.

When the probe assembly 22 is moved to the second preset position, the probe assembly 22 may also be locked, for example, the locking structure 23 is controlled to work to lock the probe assembly 22.

With the matching between the first driving module 31 and the lifter 33, the probe assembly 22 is stably pushed to the second preset position, thereby effectively completing the range adjustment in the second direction X.

According to some embodiments of the present application, referring to Figs. 1 to 9, the present application provides a testing apparatus 100. After the first driving module 31 travels to a corresponding position, the pushing member 32 proceeds to position the probe assembly 22 in a second direction X. After reaching the position, the locking structure 23 works and the limiting protrusion 224 (e.g. the ball plunger) is embedded and locked in the limiting slot 233. Moreover, the sliding member 41 in the wire arrangement structure 40 drives the probe assembly 22 to move smoothly backwards and forwards in the second direction X. With the guide wheel 43 on the wire arrangement structure 40, friction in moving of the wire harness 47 is reduced. The second driving member 121 drives the positioning member 122 to be connect to the positioning hole 141 in the slide carriage 14, and then drives the probe assembly 22 on the mount 21 to move in the first direction Y by means of the second driving module 11.

Finally, it should be noted that the above embodiments are merely used for illustrating rather than limiting the technical solutions of the present invention. The scope of the present invention is defined by the appended claims. It should be noted and understood that improvements and modifications of the embodiments described above may be made, within the scope of the appended claims. The present application is not limited to the specific embodiments disclosed herein, but rather includes all technical solutions falling within the scope of the claims.

## Claims

1. A testing apparatus, comprising:
a moving mechanism (10);
a connection mechanism (20), comprising a mount (21) and a probe assembly (22) movably disposed on the mount (21), wherein the mount (21) is disposed on the moving mechanism (10) and moved in a first direction (Y) under the action of the moving mechanism (10), and the probe assembly (22) is configured to make an electrical contact with a part to be tested; and
an adjustment mechanism (30), configured to drive the probe assembly (22) to move in a second direction (X), the first direction (Y) intersecting the second direction (X),
wherein the connection mechanism (20) further comprises a wire arrangement structure (40) and a wire harness (47), the wire arrangement structure (40) extends in the first direction (Y) and is capable of moving in the second direction (X), the wire harness (47) is wound on the wire arrangement structure (40) and electrically connected to the probe assembly (22), and the wire harness (47) on at least one side of the probe assembly (22) in the first direction (Y) has a bending section (471);
wherein the moving mechanism (10) is provided with two supporting members (44) spaced apart in the first direction (Y), the wire arrangement structure (40) comprises two sliding members (41) and a carrying member (42) connected between the two sliding members (41), the sliding members (41) are slidably disposed on the corresponding supporting members (44) in the second direction (X), and the wire harness (47) is wound on the carrying member (42),
**characterized in that**
a fixing plate (45) is provided, the fixing plate (45) is provided with lead holes (46), and the wire harness (47) passes through the lead holes (46).

2. The testing apparatus according to claim 1, wherein the adjustment mechanism (30) comprises a first driving module (31) and a pushing member (32), the first driving module (31) is configured to drive the pushing member (32) to move in the second direction (X) until it abuts against the probe assembly (22) and to push the probe assembly (22).

3. The testing apparatus according to claim 2, wherein the adjustment mechanism (30) further comprises a lifter (33) connected to the pushing member (32), the first driving module (31) is spaced apart in a third direction (Z) from the connection mechanism (20) and configured to drive the lifter (33) to move in the second direction (X), and the lifter (33) is configured to drive the pushing member (32) to move in the third direction (Z), the third direction (Z) being perpendicular to the first direction (Y) and the second direction (X), respectively.

4. The testing apparatus according to claim 1, wherein the connection mechanism (20) further comprises a locking structure (23), and the locking structure (23) is configured to lock the range-adjusted probe assembly (22) so as to restrict the probe assembly (22) from moving in the second direction (X).

5. The testing apparatus according to claim 4, wherein the locking structure (23) comprises a clamping member (232) and a first driving member (231) disposed on the mount (21), the probe assembly (22) is at least partially located between the clamping member (232) and the mount (21), and the first driving member (231) is configured to drive the clamping member (232) to move, so as to clamp or release the probe assembly (22); optionally the clamping member (232) is provided with a limiting slot (233) extending in the second direction (X), the probe assembly (22) is provided with a limiting protrusion (224), and a slot wall of the limiting slot (233) is allowed to abut against or be separated from the limiting protrusion (224) when driven by the first driving member (231).

6. The testing apparatus according to claim 1, wherein the moving mechanism (10) comprises a second driving module (11), and a mating device (12) and a carrier (13) that are disposed on the second driving module (11), the mount (21) is movably disposed on the carrier (13) in the first direction (Y), the second driving module (11) is configured to drive the mating device (12) to move in the first direction (Y), and the mating device (12) is configured to be mated or unmated with the mount (21).

7. The testing apparatus according to claim 6, wherein the moving mechanism (10) further comprises a slide carriage (14) movably disposed on the carrier (13) in the first direction (Y), the mount (21) is disposed on the slide carriage (14), and the mating device (12) is configured to be mated or unmated with the mount (21) via the slide carriage (14).

8. The testing apparatus according to claim 7, wherein the mating device (12) comprises a second driving member (121) and a positioning member (122) driven to extend or retract by the second driving member (121), and the slide carriage (14) is provided with a positioning hole (141) for insertion of the positioning member (122).

9. The testing apparatus according to claim 7, wherein the moving mechanism (10) further comprises a brake (15), the brake (15) being disposed on the slide carriage (14) and configured to restrict the slide carriage (14) from moving in the first direction (Y).

10. The testing apparatus according to claim 6, wherein at least two connection mechanisms (20) are provided, mounts (21) of all the connection mechanisms (20) are spaced apart in the first direction (Y), and the mating device (12) is allowed to be selectively mated to one of the mounts (21) under the action of the second driving module (11).

11. The testing apparatus according to any one of claims 1 to 10, wherein the wire arrangement structure (40) further comprises a guide wheel (43), the guide wheel (43) sleeves the carrying member (42), and the wire harness (47) is wound on the guide wheel (43).

12. The testing apparatus according to any one of claims 1 to 10, wherein the testing apparatus further comprises an auxiliary mechanism (50), and a testing end of the auxiliary mechanism (50) is configured to be in contact with a shell of the part to be tested.

13. A method of range adjustment for a testing apparatus, applied in the testing apparatus of any one of claims 1 to 12, comprising the steps of
controlling (S100) the moving mechanism (10) to work to drive the mount (21) to move in the first direction (Y) so as to move the probe assembly (22); and
controlling (S200) the adjustment mechanism (30) to work to drive the probe assembly (22) to move in the second direction (X).

14. The method of range adjustment for a testing apparatus according to claim 13, wherein the step of controlling the moving mechanism (10) to work to drive the mount (21) to move in the first direction (Y) comprises:
controlling (S110) the second driving module (11) to work to drive the mating device (12) to move in the first direction (Y) to the slide carriage (14) of the mount (21);
controlling (S120) the second driving member (121) of the mating device (12) to work to drive the positioning member (122) to extend out and be inserted into the positioning hole (141) of the slide carriage (14); and
controlling (S130) the second driving module (11) to work to drive the mating device (12) to move in the first direction (Y) so as to move the mount (21) to a first preset position.

15. The method of range adjustment for a testing apparatus according to claim 13, wherein the step of controlling the adjustment mechanism (30) to work to drive the probe assembly (22) to move in the second direction (X) comprises:
controlling (S210) the first driving module (31) to work to drive the lifter (33) to move in the second direction (X) to one side of the probe assembly (22);
controlling (S220) the lifter (33) to work to drive the pushing member (32) to move in the third direction (Z) so that the pushing member (32) is allowed to be in contact with the probe assembly (22); and
controlling (S230) the first driving module (31) to work to drive the lifter (33) to move in the second direction (X) so that the probe assembly (22) is driven to move to a second preset position by means of the pushing member (32).

## Patentansprüche

1. Prüfvorrichtung, umfassend:
einen Bewegungsmechanismus (10);
einen Verbindungsmechanismus (20), umfassend eine Halterung (21) und eine Sondenanordnung (22), die beweglich an der Halterung (21) angeordnet ist, wobei die Halterung (21) an dem Bewegungsmechanismus (10) angeordnet ist und unter der Wirkung des Bewegungsmechanismus (10) in einer ersten Richtung (Y) bewegt wird, und wobei die Sondenanordnung (22) dazu eingerichtet ist, einen elektrischen Kontakt mit einem zu prüfenden Teil herzustellen; und
einen Einstellmechanismus (30), der dazu eingerichtet ist, die Sondenanordnung (22) anzutreiben, sich in einer zweiten Richtung (X) zu bewegen, wobei die erste Richtung (Y) die zweite Richtung (X) schneidet,
wobei der Verbindungsmechanismus (20) ferner eine Kabelanordnungsstruktur (40) und einen Kabelbaum (47) umfasst, wobei sich die Kabelanordnungsstruktur (40) in der ersten Richtung (Y) erstreckt und in der zweiten Richtung (X) bewegbar ist, der Kabelbaum (47) auf die Kabelanordnungsstruktur (40) gewickelt und elektrisch mit der Sondenanordnung (22) verbunden ist, und der Kabelbaum (47) auf mindestens einer Seite der Sondenanordnung (22) in der ersten Richtung (Y) einen Biegeabschnitt (471) aufweist;
wobei der Bewegungsmechanismus (10) mit zwei Stützelementen (44) versehen ist, die in der ersten Richtung (Y) voneinander beabstandet sind, die Kabelanordnungsstruktur (40) zwei Gleitelemente (41) und ein Tragelement (42), das zwischen den zwei Gleitelementen (41) verbunden ist, umfasst, die Gleitelemente (41) in der zweiten Richtung (X) gleitbar an den entsprechenden Stützelementen (44) angeordnet sind, und der Kabelbaum (47) auf das Tragelement (42) gewickelt ist,
**dadurch gekennzeichnet, dass**
eine Befestigungsplatte (45) vorgesehen ist, die Befestigungsplatte (45) mit Durchführungsöffnungen (46) versehen ist, und der Kabelbaum (47) durch die Durchführungsöffnungen (46) hindurchtritt.

2. Prüfvorrichtung nach Anspruch 1, wobei der Einstellmechanismus (30) ein erstes Antriebsmodul (31) und ein Schubelement (32) umfasst, wobei das erste Antriebsmodul (31) dazu eingerichtet ist, das Schubelement (32) anzutreiben, sich in der zweiten Richtung (X) zu bewegen, bis es an der Sondenanordnung (22) anliegt, und die Sondenanordnung (22) zu schieben.

3. Prüfvorrichtung nach Anspruch 2, wobei der Einstellmechanismus (30) ferner einen Heber (33) umfasst, der mit dem Schubelement (32) verbunden ist, wobei das erste Antriebsmodul (31) in einer dritten Richtung (Z) von dem Verbindungsmechanismus (20) beabstandet ist und dazu eingerichtet ist, den Heber (33) anzutreiben, sich in der zweiten Richtung (X) zu bewegen, und wobei der Heber (33) dazu eingerichtet ist, das Schubelement (32) anzutreiben, sich in der dritten Richtung (Z) zu bewegen, wobei die dritte Richtung (Z) jeweils senkrecht zu der ersten Richtung (Y) und der zweiten Richtung (X) ist.

4. Prüfvorrichtung nach Anspruch 1, wobei der Verbindungsmechanismus (20) ferner eine Verriegelungsstruktur (23) umfasst, und die Verriegelungsstruktur (23) dazu eingerichtet ist, die bereichseingestellte Sondenanordnung (22) zu verriegeln, um die Sondenanordnung (22) daran zu hindern, sich in der zweiten Richtung (X) zu bewegen.

5. Prüfvorrichtung nach Anspruch 4, wobei die Verriegelungsstruktur (23) ein Klemmelement (232) und ein erstes Antriebselement (231), das an der Halterung (21) angeordnet ist, umfasst, die Sondenanordnung (22) zumindest teilweise zwischen dem Klemmelement (232) und der Halterung (21) angeordnet ist, und das erste Antriebselement (231) dazu eingerichtet ist, das Klemmelement (232) anzutreiben, sich zu bewegen, um die Sondenanordnung (22) zu klemmen oder freizugeben; wobei optional das Klemmelement (232) mit einer Begrenzungsnut (233) versehen ist, die sich in der zweiten Richtung (X) erstreckt, die Sondenanordnung (22) mit einem Begrenzungsvorsprung (224) versehen ist, und eine Nutwand der Begrenzungsnut (233) unter Antrieb durch das erste Antriebselement (231) an dem Begrenzungsvorsprung (224) anliegen oder von diesem getrennt werden kann.

6. Prüfvorrichtung nach Anspruch 1, wobei der Bewegungsmechanismus (10) ein zweites Antriebsmodul (11) sowie eine Kopplungsvorrichtung (12) und einen Träger (13), die an dem zweiten Antriebsmodul (11) angeordnet sind, umfasst, wobei die Halterung (21) in der ersten Richtung (Y) beweglich an dem Träger (13) angeordnet ist, das zweite Antriebsmodul (11) dazu eingerichtet ist, die Kopplungsvorrichtung (12) anzutreiben, sich in der ersten Richtung (Y) zu bewegen, und die Kopplungsvorrichtung (12) dazu eingerichtet ist, mit der Halterung (21) gekoppelt oder von der Halterung (21) entkoppelt zu werden.

7. Prüfvorrichtung nach Anspruch 6, wobei der Bewegungsmechanismus (10) ferner einen Gleitschlitten (14) umfasst, der in der ersten Richtung (Y) beweglich an dem Träger (13) angeordnet ist, die Halterung (21) an dem Gleitschlitten (14) angeordnet ist, und die Kopplungsvorrichtung (12) dazu eingerichtet ist, über den Gleitschlitten (14) mit der Halterung (21) gekoppelt oder von der Halterung (21) entkoppelt zu werden.

8. Prüfvorrichtung nach Anspruch 7, wobei die Kopplungsvorrichtung (12) ein zweites Antriebselement (121) und ein Positionierelement (122), das durch das zweite Antriebselement (121) zum Ausfahren oder Einfahren angetrieben wird, umfasst, und der Gleitschlitten (14) mit einem Positionierloch (141) zum Einführen des Positionierelements (122) versehen ist.

9. Prüfvorrichtung nach Anspruch 7, wobei der Bewegungsmechanismus (10) ferner eine Bremse (15) umfasst, wobei die Bremse (15) an dem Gleitschlitten (14) angeordnet und dazu eingerichtet ist, den Gleitschlitten (14) daran zu hindern, sich in der ersten Richtung (Y) zu bewegen.

10. Prüfvorrichtung nach Anspruch 6, wobei mindestens zwei Verbindungsmechanismen (20) vorgesehen sind, Halterungen (21) aller Verbindungsmechanismen (20) in der ersten Richtung (Y) voneinander beabstandet sind, und die Kopplungsvorrichtung (12) unter der Wirkung des zweiten Antriebsmoduls (11) selektiv mit einer der Halterungen (21) gekoppelt werden kann.

11. Prüfvorrichtung nach einem der Ansprüche 1 bis 10, wobei die Kabelanordnungsstruktur (40) ferner ein Führungsrad (43) umfasst, das Führungsrad (43) das Tragelement (42) umgibt, und der Kabelbaum (47) auf das Führungsrad (43) gewickelt ist.

12. Prüfvorrichtung nach einem der Ansprüche 1 bis 10, wobei die Prüfvorrichtung ferner einen Hilfsmechanismus (50) umfasst, und ein Prüfende des Hilfsmechanismus (50) dazu eingerichtet ist, mit einem Gehäuse des zu prüfenden Teils in Kontakt zu stehen.

13. Verfahren zur Bereichseinstellung für eine Prüfvorrichtung, angewendet in der Prüfvorrichtung nach einem der Ansprüche 1 bis 12, umfassend die Schritte: Steuern (S100) des Bewegungsmechanismus (10) zum Arbeiten, um die Halterung (21) anzutreiben, sich in der ersten Richtung (Y) zu bewegen, um die Sondenanordnung (22) zu bewegen; und Steuern (S200) des Einstellmechanismus (30) zum Arbeiten, um die Sondenanordnung (22) anzutreiben, sich in der zweiten Richtung (X) zu bewegen.

14. Verfahren zur Bereichseinstellung für eine Prüfvorrichtung nach Anspruch 13, wobei der Schritt des Steuerns des Bewegungsmechanismus (10) zum Arbeiten, um die Halterung (21) anzutreiben, sich in der ersten Richtung zu bewegen, umfasst:
Steuern (S110) des zweiten Antriebsmoduls (11) zum Arbeiten, um die Kopplungsvorrichtung (12) anzutreiben, sich in der ersten Richtung (Y) zu dem Gleitschlitten (14) der Halterung (21) zu bewegen;
Steuern (S120) des zweiten Antriebselements (121) der Kopplungsvorrichtung (12) zum Arbeiten, um das Positionierelement (122) anzutreiben, auszufahren und in das Positionierloch (141) des Gleitschlittens (14) eingeführt zu werden; und
Steuern (S130) des zweiten Antriebsmoduls (11) zum Arbeiten, um die Kopplungsvorrichtung (12) anzutreiben, sich in der ersten Richtung (Y) zu bewegen, um die Halterung (21) zu einer ersten vorgegebenen Position zu bewegen.

15. Verfahren zur Bereichseinstellung für eine Prüfvorrichtung nach Anspruch 13, wobei der Schritt des Steuerns des Einstellmechanismus (30) zum Arbeiten, um die Sondenanordnung (22) anzutreiben, sich in der zweiten Richtung (X) zu bewegen, umfasst:
Steuern (S210) des ersten Antriebsmoduls (31) zum Arbeiten, um den Heber (33) anzutreiben, sich in der zweiten Richtung (X) zu einer Seite der Sondenanordnung (22) zu bewegen;
Steuern (S220) des Hebers (33) zum Arbeiten, um das Schubelement (32) anzutreiben, sich in der dritten Richtung zu bewegen, so dass das Schubelement (32) mit der Sondenanordnung (22) in Kontakt stehen kann; und
Steuern (S230) des ersten Antriebsmoduls (31) zum Arbeiten, um den Heber (33) anzutreiben, sich in der zweiten Richtung (X) zu bewegen, so dass die Sondenanordnung (22) mittels des Schubelements (32) angetrieben wird, sich zu einer zweiten vorgegebenen Position zu bewegen.

## Revendications

1. Appareil de test, comprenant : un mécanisme de déplacement (10) ;
un mécanisme de connexion (20), comprenant un support (21) et un ensemble de sondes (22) disposé de manière mobile sur le support (21), dans lequel le support (21) est disposé sur le mécanisme de déplacement (10) et déplacé dans une première direction (Y) sous l'action du mécanisme de déplacement (10), et l'ensemble de sondes (22) est configuré pour établir un contact électrique avec une pièce à tester ; et
un mécanisme de réglage (30), configuré pour entraîner l'ensemble de sondes (22) à se déplacer dans une deuxième direction (X), la première direction (Y) croisant la deuxième direction (X),
dans lequel le mécanisme de connexion (20) comprend en outre une structure d'agencement de fils (40) et un faisceau de fils (47), la structure d'agencement de fils (40) s'étend dans la première direction (Y) et est capable de se déplacer dans la deuxième direction (X), le faisceau de fils (47) est enroulé sur la structure d'agencement de fils (40) et connecté électriquement à l'ensemble de sondes (22), et le faisceau de fils (47) situé sur au moins un côté de l'ensemble de sondes (22) dans la première direction (Y) présente une section de flexion (471) ;
dans lequel le mécanisme de déplacement (10) est pourvu de deux éléments de support (44) espacés l'un de l'autre dans la première direction (Y), la structure d'agencement de fils (40) comprend deux éléments coulissants (41) et un élément porteur (42) connecté entre les deux éléments coulissants (41), les éléments coulissants (41) sont disposés de manière coulissante sur les éléments de support (44) correspondants dans la deuxième direction (X), et le faisceau de fils (47) est enroulé sur l'élément porteur (42),
**caractérisé en ce que**
une plaque de fixation (45) est prévue, la plaque de fixation (45) est pourvue de trous de passage (46), et le faisceau de fils (47) passe à travers les trous de passage (46).

2. Appareil de test selon la revendication 1, dans lequel le mécanisme de réglage (30) comprend un premier module d'entraînement (31) et un élément de poussée (32), le premier module d'entraînement (31) étant configuré pour entraîner l'élément de poussée (32) à se déplacer dans la deuxième direction (X) jusqu'à ce qu'il vienne en butée contre l'ensemble de sondes (22), et pour pousser l'ensemble de sondes (22).

3. Appareil de test selon la revendication 2, dans lequel le mécanisme de réglage (30) comprend en outre un élévateur (33) connecté à l'élément de poussée (32), le premier module d'entraînement (31) est espacé du mécanisme de connexion (20) dans une troisième direction (Z) et configuré pour entraîner l'élévateur (33) à se déplacer dans la deuxième direction (X), et l'élévateur (33) est configuré pour entraîner l'élément de poussée (32) à se déplacer dans la troisième direction (Z), la troisième direction (Z) étant respectivement perpendiculaire à la première direction (Y) et à la deuxième direction (X).

4. Appareil de test selon la revendication 1, dans lequel le mécanisme de connexion (20) comprend en outre une structure de verrouillage (23), et la structure de verrouillage (23) est configurée pour verrouiller l'ensemble de sondes (22) dont la plage a été réglée, afin d'empêcher l'ensemble de sondes (22) de se déplacer dans la deuxième direction (X).

5. Appareil de test selon la revendication 4, dans lequel la structure de verrouillage (23) comprend un élément de serrage (232) et un premier élément d'entraînement (231) disposé sur le support (21), l'ensemble de sondes (22) est situé au moins partiellement entre l'élément de serrage (232) et le support (21), et le premier élément d'entraînement (231) est configuré pour entraîner l'élément de serrage (232) à se déplacer, afin de serrer ou de libérer l'ensemble de sondes (22) ; éventuellement, l'élément de serrage (232) est pourvu d'une rainure de limitation (233) s'étendant dans la deuxième direction (X), l'ensemble de sondes (22) est pourvu d'une saillie de limitation (224), et une paroi de rainure de la rainure de limitation (233) est autorisée à venir en butée contre la saillie de limitation (224) ou à s'en séparer lorsqu'elle est entraînée par le premier élément d'entraînement (231).

6. Appareil de test selon la revendication 1, dans lequel le mécanisme de déplacement (10) comprend un deuxième module d'entraînement (11), ainsi qu'un dispositif d'accouplement (12) et un porteur (13) qui sont disposés sur le deuxième module d'entraînement (11), le support (21) est disposé de manière mobile sur le porteur (13) dans la première direction (Y), le deuxième module d'entraînement (11) est configuré pour entraîner le dispositif d'accouplement (12) à se déplacer dans la première direction (Y), et le dispositif d'accouplement (12) est configuré pour être accouplé avec le support (21) ou désaccouplé de celui-ci.

7. Appareil de test selon la revendication 6, dans lequel le mécanisme de déplacement (10) comprend en outre un chariot coulissant (14) disposé de manière mobile sur le porteur (13) dans la première direction (Y), le support (21) est disposé sur le chariot coulissant (14), et le dispositif d'accouplement (12) est configuré pour être accouplé avec le support (21) ou désaccouplé de celui-ci par l'intermédiaire du chariot coulissant (14).

8. Appareil de test selon la revendication 7, dans lequel le dispositif d'accouplement (12) comprend un deuxième élément d'entraînement (121) et un élément de positionnement (122) entraîné à s'étendre ou à se rétracter par le deuxième élément d'entraînement (121), et le chariot coulissant (14) est pourvu d'un trou de positionnement (141) destiné à l'insertion de l'élément de positionnement (122).

9. Appareil de test selon la revendication 7, dans lequel le mécanisme de déplacement (10) comprend en outre un frein (15), le frein (15) étant disposé sur le chariot coulissant (14) et configuré pour empêcher le chariot coulissant (14) de se déplacer dans la première direction (Y).

10. Appareil de test selon la revendication 6, dans lequel au moins deux mécanismes de connexion (20) sont prévus, les supports (21) de tous les mécanismes de connexion (20) sont espacés les uns des autres dans la première direction (Y), et le dispositif d'accouplement (12) est autorisé à être accouplé sélectivement à l'un des supports (21) sous l'action du deuxième module d'entraînement (11).

11. Appareil de test selon l'une quelconque des revendications 1 à 10, dans lequel la structure d'agencement de fils (40) comprend en outre une roue de guidage (43), la roue de guidage (43) entoure l'élément porteur (42), et le faisceau de fils (47) est enroulé sur la roue de guidage (43).

12. Appareil de test selon l'une quelconque des revendications 1 à 10, dans lequel l'appareil de test comprend en outre un mécanisme auxiliaire (50), et une extrémité de test du mécanisme auxiliaire (50) est configurée pour être en contact avec une coque de la pièce à tester.

13. Procédé de réglage de plage pour un appareil de test, appliqué dans l'appareil de test selon l'une quelconque des revendications 1 à 12, comprenant les étapes consistant à commander (S100) le mécanisme de déplacement (10) pour fonctionner afin d'entraîner le support (21) à se déplacer dans la première direction (Y) de manière à déplacer l'ensemble de sondes (22) ; et à commander (S200) le mécanisme de réglage (30) pour fonctionner afin d'entraîner l'ensemble de sondes (22) à se déplacer dans la deuxième direction (X).

14. Procédé de réglage de plage pour un appareil de test selon la revendication 13, dans lequel l'étape consistant à commander le mécanisme de déplacement (10) pour fonctionner afin d'entraîner le support (21) à se déplacer dans la première direction comprend :
la commande (S110) du deuxième module d'entraînement (11) pour fonctionner afin d'entraîner le dispositif d'accouplement (12) à se déplacer dans la première direction (Y) jusqu'au chariot coulissant (14) du support (21) ;
la commande (S120) du deuxième élément d'entraînement (121) du dispositif d'accouplement (12) pour fonctionner afin d'entraîner l'élément de positionnement (122) à s'étendre et à être inséré dans le trou de positionnement (141) du chariot coulissant (14) ; et
la commande (S130) du deuxième module d'entraînement (11) pour fonctionner afin d'entraîner le dispositif d'accouplement (12) à se déplacer dans la première direction (Y), de manière à déplacer le support (21) vers une première position prédéfinie.

15. Procédé de réglage de plage pour un appareil de test selon la revendication 13, dans lequel l'étape consistant à commander le mécanisme de réglage (30) pour fonctionner afin d'entraîner l'ensemble de sondes (22) à se déplacer dans la deuxième direction (X) comprend :
la commande (S210) du premier module d'entraînement (31) pour fonctionner afin d'entraîner l'élévateur (33) à se déplacer dans la deuxième direction (X) jusqu'à un côté de l'ensemble de sondes (22) ;
la commande (S220) de l'élévateur (33) pour fonctionner afin d'entraîner l'élément de poussée (32) à se déplacer dans la troisième direction de sorte que l'élément de poussée (32) soit autorisé à être en contact avec l'ensemble de sondes (22) ; et
la commande (S230) du premier module d'entraînement (31) pour fonctionner afin d'entraîner l'élévateur (33) à se déplacer dans la deuxième direction (X), de sorte que l'ensemble de sondes (22) soit entraîné à se déplacer vers une deuxième position prédéfinie au moyen de l'élément de poussée (32).
